# EUROPEAN PATENT APPLICATION

(11) **EP 1 770 072 A1**
(43) Date of publication of application: **04.04.2007**
(21) Application number: 06019638.3
(22) Date of filing: 20.09.2006
(51) Int. Cl.: C03C 25/26, C08J 5/08

(54) **Method of making nonwoven fibrous mats and preforms and methods of use**

(30) Priority: 29.09.2005 US 238452
(71) Applicant: Johns Manville, Denver CO 80202 (US)
(72) Inventor: Gleich, Klaus Friedrich, Highlands Ranch, CO 80126 (US)
(74) Representative: Luderschmidt, Schüler & Partner

(57) **Abstract**

Sizing compositions for fibers having a viscosity of greater than about 300 centipoise and a binder resin concentration of at least about 90 wt. percent based on the dry weight of sizing chemicals in the sizing are disclosed. Wet, sized glass fibers having such a sizing on their surface and having an LOI of at least about 1 wt. percent are used to make mats by conventional dry laid and preform processes without having to add any additional binder to bond the fibers together. Wet sized, chopped glass fiber products and wet sized fiber roving products having a moisture content of 0.5 to about 20 wt. percent or higher are disclosed. Methods of making wet sized fibers of the invention are disclosed. Methods of using these sized glass fibers to make nonwoven fibrous mats and preforms are also disclosed.

## Description

The present invention involves nonwoven mats and preform made by bonding sized fibers together in a random array. These mats are particularly useful in the manufacture of reinforced polymer shapes using SRIM, vacuum molding and other processes involving forcing or drawing one or more polymers or polymer mixtures into an array of reinforcing fibers.

### BACKGROUND

It is known to make reinforcing nonwoven mats from fibers and to use these mats as substrates in the manufacture of a large number of products including structural panels, see 5,547,743. Methods of making nonwoven mats are also known, such as conventional wet laid processes described in U. S. Patent Nos. 4,112,174, 4,681,802 and 4,810,576, the disclosures of which are hereby incorporated herein by reference. In these processes a slurry of glass fiber is made by adding fiber to a typical white water in a pulper to,disperse the fiber in the white water forming a slurry having a fiber concentration of about 0.2-1.0 weight %, metering the slurry into a flow of white water to dilute the fiber concentration to 0.1 or below, and depositing this mixture on to a moving screen forming wire to dewater and form a wet nonwoven fibrous mat. The wet nonwoven web of fiber is then transferred to a second moving screen in-line with the forming screen and run through a binder application saturating station where an aqueous binder mixture, such as an aqueous urea formaldehyde (UF) resin based binder mixture, is applied to the mat in any one of several known ways. The binder-saturated mat is then run over a suction section while still on the moving screen to remove excess binder. The wet mat is then transferred to a wire mesh moving belt and run through an oven to dry the wet mat and to cure (polymerize) the UF based resin binder which bonds the fibers together in the mat. In these processes the aqueous binder solution is applied using a curtain coater or a dip and squeeze applicator, but other methods of application such as spraying are also known. In the drying and curing oven the mat is subjected to temperatures up to 450 or 500 degrees F or higher for periods usually not exceeding 1-2 minutes and as little as a few seconds. These wet processes require tens of millions of dollars of capital expenditure, a factor that prohibits their use for most individual molders. Also, this and the further fact that these processes run very fast and are most suitable for large volume products makes small volumes of mats made for special reinforcement processes much more costly for small runs and often prohibitively costly.

Alternative forming methods for nonwoven fiber mats include the use of well known processes of cylinder forming, continuous strand mat forming which lays continuous strands of glass fibers in overlapping swirls, and "dry laying" using carding or random fiber distribution. Such processes are disclosed in US Pat. Nos. 4,012,553, 4,054,713 and 5,382,148. In the dry forming processes the fiber is dry, but in US 2005/0035478 A1, the process uses wet sized fibers, containing 5-30 percent moisture, by feeding the wet sized fibers to a bale opener. In all of these processes it is necessary to add resin fibers, resin powder, resin flake or liquid resin binder to the nonwoven web before heating to bond the fibers together to form a mat or perform having enough strength for handling into the mold or press. These processes require less capital expenditure, and have a lower productivity, making them more suitable for making lower volume runs of reinforcing mats and performs for specialty reinforcement processes. One major disadvantage of these processes is the cost of the binder fibers or the cost and headaches of the binder application eq uipment. The technology in the form of chemical engineers and technicians needed to operate binder preparat ion equipment and to maintain needed binder formulation technology is also very expensive. The use of most binders and the equipment used to apply them to the fibers adds substantial capital costs, environmental problems and substantial associated costs and big housekeeping problems and costs.

The above processes use sized glass fibers and sometimes also polymer fibers mixed in with the sized glass fibers. It is old to put a chemical sizing on glass fibers and important to the performance of the fibers, particularly when they are to be used in a polymer matrix. Sizings normally contain a film former to retain the other ingredients on the fiber, one or more silanes to promote bonding of the glass fibers to the polymer matrix and a lubricant to protect the surface of the glass fibers from scratches that greatly reduce the strength of the fibers. For fibers manufactured for wet forming processes for making nonwoven mats, the sizing content on the fibers amounts to about 0.5 wt. percent or less of the fiber and the moisture content of the wet sized fibers is normally in the range of about 12-18 wt. percent and the fibers are chopped to a length of about 0.25 inch to about 3 inches. Wet chopped and sized fibers produced for dry processes are normally produced as a roving containing several hundred fibers and then dried. The glass fibers normally contain a sizing content on their surfaces of less than about 1 wt. percent at least about 1 wt. percent, more typically at least about 1.2 wt. percent and most typically at least about 1.5 wt. percent, such as 2-3 wt. percent or more. In the sizings on the fibers the film former is normally a resin and the film former would normally constitute a major portion of the sizing composition, on a dry basis. Of the LOI of the conventionally sized fiber, the resin binder typically constitutes about 70-90 percent of the sizing on the fiber.

It would be desirable to be able to make these mats and preforms without having to use binder fibers, or as much binder fibers, and without having to invest and operate binder application equipment.

### SUMMARY OF THE INVENTION

The invention includes a method of making mats and preform by using wet, sized fiber wherein the amount of resin binder in the sizing on the fiber is substantially different that used before and sufficient to bind a wet web of the fibers together by only drying and heating the web to remove the liquid on the fibers and to cure the resin in the sizing. The sizing used in the present invention contains a resin binder that acts as a film former, or is in addition to a known film former, and the amount of sizing on the fiber is at least about 1 wt. percent, more typically at least about 1.2 wt. percent and most typically at least about 1.5 wt. percent, including 2-5 wt. percent or more. The film former is normally a resin, or mixture of resins and typically constitutes a major portion of the sizing composition, on a dry basis. Of the LOI of the sized fiber, the resin binder, including a film former when a combination is used in the sizing, would typically constitute at least about 90 wt. percent of the sizing composition, on a dry basis, on the fiber more typically at least about 92 wt. percent and most typically at least about 93 wt. percent. Resin contents of at least 95 wt. percent such as at least about 97 wt. percent or even at least about 99 wt. percent or at least about 99.5 wt. percent of the solids in the sizing are suitable in the invention, the higher concentration producing the best results except for tackiness of the fiber.

The sizing will also contain a linking compound that bonds to both the fiber surface and also to the film former and/or matrix that will eventually surround the fibers in a composite product. This linking compound is typically an organooxysilane such as gammaamineopropyltrimethoxysilane, gammamethylacryltrimethoxysilane and the like. A typical organooxylilane is A-1100, available from Union Carbide. The sizing can also optionally contain a lubricant compound to protect the surface of the fiber, but often the film former resin or resin mixture, emulsion, suspension, etc. serves as a suitable lubricant.

The film former in the sizings used in the invention is selected to bond well to the matrix that the fiber will be in contact with in the composite and also to bond the fibers or fiber bundles together sufficiently after the fibers and fiber bundles are formed into a mat or preform to provide enough strength after drying to permit the resultant mat or preform to be, optionally packaged, optionally shipped and handled into a mold without tearing or excessively distorting the mat or perform. Typical film formers useful in the invention are epoxy polymers, nylons, polyurethanes, epoxy/polyurethane copolymers, acrylics, urea formaldehyde resins, melamine resins, and other resins compatible with aqueous systems and used to bond fibers together. The sizings can also contain other functional ingredients such as an effective amount of fungicide to prevent bacterial action during storage and shipment of the wet, sized fibers and fiber bundles.

The sizings used in the invention are typically aqueous emulsions, latexes, suspensions, or solutions. Effective amounts of one or more emulsifiers, surfactants, biocides and anti-static agents can also be present in the sizing compositions as is common practice. The solids content of these sizings can be higher than is typically used in aqueous sizing compositions and typically is in the range of about 5 to about 35 wt. percent, more typically about 10 to about 25 wt. percent and most typically about 12 to about 20 wt. percent. The amount of sizing on the fibers or fiber bundles when the fibers or fiber bundles are ready for forming a mat or perform is such as to produce a loss on ignition, LOI, of the sized fibers in the range of about 1 to about 6 wt. percent or more, dry basis, and typically is about 2 to about 5 wt. percent or more, most typically is in the range of about 2.5 or 3 to about 5 wt. percent or more. The moisture content on the wet sized fibers and fiber bundles is usually in the range of about 10 to about 35 wt. percent, more typically about 12 to about 30 wt. percent and most typically about 12 to about 25 wt. percent.

The fibers are made in a conventional manner, such as disclosed in US Pat. Nos. 6,415,997, 6,202,525, 5,003,855, 4,706,531, 4,411,180 and 4,615,245, the disclosures of which are herein incorporated by reference. The type of sizing and the amount on the fiber is also applied in a conventional manner. Several hundred or several thousand of the sized fibers are gathered into a strand and one or more strands of sized fibers are wound into rovings or run through a chopper to reduce the length of the fibers and strands of fibers to a length in the range of about 0.5 to about 5 inches or longer, more typically about 0.75 to about 4 inches or longer, even more typically about 1 to about 3.5 inches or longer and most typically about 1.25 inches to about 4 inches or longer. The wet fibers are packaged, or are laid onto a moving collection belt in a random pattern in a conventional manner to form a web. The wet sized fibers can also be in the form of wet roving packages of wound wet rovings and can be put in plastic bags or other water proof packaging and shipped. At the user site, the rovings can then be chopped or laid down in swirls to form a continuous strand mat in a known manner and then dried to form a continuous strand mat for making composites. The moisture content of the wet sized fiber as it comes off of a chopper or off of a rovings winder will have a moisture content in the range of about 9 to about 20 wt. percent or even higher, more typically in the range of about 10 to about 18 wt. percent. This is the moisture content typically in the wet sized fiber used to make mats according to the invention.

Prior to packaging, the wet sized chopped fiber strands and wet roving can optionally be heated to remove some of the moisture in a known manner, typically to produce a moisture content, when the fiber is ready to use according to the invention, or to blend with a hot polymer or polymer mixture, in a range of about 8 wt. percent to about 0.5 wt. percent, more typically to a range of about 8 wt. percent to about 1 wt. percent and most typically in a range of about 0.5 to about 6 wt. percent. The wet sized fibers can be used to form mats according to the invention or can be fed wet into a compounder, plasticizer, injection molding system or other fiber reinforced composite making system. The wet sized fiber may contain a small amount of dryer fiber, i.e. having a moisture content of less than about 0.5 wt. percent as it exits from the moisture reducing apparatus, but it will quickly reabsorb moisture from wetter sized fiber in contact in the package and prior to reaching the time of use.

There is a limit to the amount of sizing that will stay on the fibers in the process of making and chopping the fibers. Below the sizing applicator in most processes there is a wheel, stationary or turning, that is used to turn the strand of fibers, usually several thousand fibers in the strand, approximately about 90 degrees. This wheel is usually only a few inches in diameter and the strand is usually moving at a high rate of speed, several thousand feet per minute. The centrifugal force caused by turning around a small radius at this high speed throws sizing off of the fiber. To reduce the amount of sizing loss at this point in the process a larger diameter wheel is used to turn the strand of fiber, a wheel having a strand contact diameter of at least 4 inches, more typically at least 5 inches and most typically at least about 6 inches, such as 7-12 inches or larger. It is also best, but not necessary, if the wheel is driven at the same surface speed as the fiber strand is running to prevent this wheel from rubbing sizing off of the fiber strand.

Most high-speed choppers for chopping sized fiber strands also cause the fibers to loose sizing, do to the centrifugal force caused by a rapidly turning backup roll. For this reason it is desirable to use a chopper having a large backup roll, such as at least about 24 inches in diameter, more typically at least about 30 inches and most typically at least about 33 inches. In practicing the invention additional sizing can be sprayed on the fibers after they are chopped and before they are formed into a web or mat or perform.. A good place and manner of doing this is to spray the sizing into the array of fibers and fiber bundles between the chopper and the collection belt or other collection device or package. Choppers used to chop the continuous strands of sized fibers throw off the chopped bundles of fibers in a fan-shaped array with the bundles being separated from one another. In this situation, the sizing spray can contact all of the bundles. It is desirable to locate sprays to spray from two or more directions to contact more of the surface of the bundles with the sizing spray. According to the invention it is possible to apply none or up to 90 percent of the sizing on the finished fiber bundles after the strands of fibers are chopped, but more typically to apply about 25-75 percent of the sizing in this manner. The bundles coming from the chopper can contain single fibers, but more typically contain from a few dozen fibers up to several thousand fibers.

The wet, sized fiber bundles can be packaged and shipped or can be transported directly to a feeding and opening device. If desired, polymer fibers and/or a small percentage of resin binder fibers can be dispersed in with the glass fibers in the web by either mixing them with the wet, sized glass fibers as the latter is being chopped, or as the glass fiber bundles are being laid upon a collection belt on in a box for shipment, or onto a preform mold or on a moving collection belt for forming the web of sized fibers.

The bundles of sized fibers are next dumped or transported to a fiber feeder, usually a gravimetric or volumetric feeder where the wet sized fiber bundles are metered out. The feeder can be modified to have one or two opposed rollers having pins or other small diameter projections extending from the surface. The roll or rolls are rotated rapidly to catch the bundles and to open the bundles into many smaller bundles of fibers and to project the small bundles onto a moving collection surface, usually permeable, or a permeable preform mold. One suitable opener/feeder of this type is a Formfiber SPIKE^{™} feeder available from Formfiber Denmark ApS of Hasselager, Denmark. Bale openers can also be used as can a Brabender^{™} feeder.^{L}

Using these types of feeder/openers, a web of randomly laid fiber bundles is formed on a collection belt, usually a moving belt. It is desirable to be drawing a flow of air through the permeable collection surface or mold as the fibers and small bundles of fibers are being projected thereon. The flow of air aids in directing the fibers and small bundles in a random pattern uniformly onto the permeable surface and compacts the fibers and small bundles into close contact. The web of fibers or the preform is then run through an oven to remove the moisture from the web and to heat the binder in the sizing, and resin binder fibers when present, to a sufficient temperature to bond the fibers in the web together. The bonded web of fibers can then be wound up or cut into sections for use in SRIM or other composite molding equipment. The preform can be nested together for packaging and shipment or transported to the composite forming press such as a RIM or SRIM or other forming mold.

A method of making preform is also included in the invention in which the chopped, wet, sized bundles of fibers described in the previous paragraph are opened and blown onto a permeable screen mold to form a preform in a known manner. After forming, the preform are fed through the oven to remove the moisture and to activate the resin binder in the sizing to the dry preform can either be packaged for storage or shipment or can be transported to a composite forming machine such as a RIM machine and molded into a composite in a known manner.

Various modifications can be made to the above processes for making nonwoven mat or preform for polymer reinforcement as is known in the forming processes used. Also, many sizing compositions can be used in these processes, usually tailoring the sizing to the specific composite matrix and/or composite forming process. The resins useful as film formers and fiber binders in the sizing include polyvinyl alcohol, polyvinyl acetate, acrylic resins including polyacrylic acid solution polymer, urethane latexes, epoxies, polyvinyl pyrilidone, polyvinyl chloride, styrene butadiene, polyamide resins, thermoplastic particles or latexes containing polypropylene, polyethylene, nylon. The resin or resins used in the sizing as the binder should be selected to be compatible with the matrix polymer(s) that will be mixed with the fiber to form a composite product.

Nonwoven mats used in the laminate invention can have basis weights in the range of about 0.5 lbs. per 100 sq. feet or greater and comprise sized glass fibers and can also comprise polymer fibers, the glass fibers and other fibers being bonded together with a dry and cured binder in the sizing on the glass fibers.

Typically glass fiber is used in the invention. The diameter or type of glass fiber is not critical but most typically chopped continuous E glass K or M diameter fiber, fibers having an average fiber diameter of about 8-16 microns and up to at least about 30 microns are used. Although this is most typical, microfibers having diameters as low as1 micron or less can be used as can insulation type fibers. S glass, T glass, R glass, and C glass fibers can also be used as can ceramic fibers, carbon fibers and metal fibers. Other non-g lass fibers that do not include binder fibers can be used in amounts up to equal amounts of the glass fibers present. Also, other fibers that can also include binder fibers like nylon, polyester, polyethylene, and others can be present in amounts up to at about 5, 10, 15 or as high as about 25 wt. percent of the fibers. A small amount of the fibers can even be bleached cellulosic fibers or fibers derived from a cellulosic material.

Laminates of the invention can comprise two or more layers of fibrous nonwoven mat described above, but more typically comprises three or more layers of fibrous nonwoven mat. The thickness of the laminate, before applying a fabric cover to one or both sides of the laminate, can be a matter of choice.

The invention also includes processes of making the nonwoven mats and preform described above by opening the wet sized fibers and either distributing them onto a moving carrier belt or onto a permeable preformed mold followed by drying the mat or perform and heating the dry perform to melt or cure the binder followed by cooling the mat or perform to form a bonded fibrous nonwoven mat or perform and processes for using these mats and performs in composite molding processes in known ways to produce either SMC type material or a molded composite shapes comprising one or more polymers or polymer mixtures reinforced with glass fibers.

When the word "about" is used herein it is meant that the amount or condition it modifies can vary some beyond that stated so long as the advantages of the invention are realized. Practically, there is rarely the time or resources available to very precisely determine the limits of all the parameters of ones invention because to do would require an effort far greater than can be justified at the time the invention is being developed to a commercial reality. The skilled artisan understands this and expects that the disclosed results of the invention might extend, at least somewhat, beyond one or more of the limits disclosed. Later, having the benefit of the inventors disclosure and understanding the inventive concept, the objectives of the invention and em bodiments disclosed, including the best mode known to the inventor, the inventor and others can, without inventive effort, explore beyond the limits disclosed using only ordinary skill to determine if the invention is realized beyond those limits, and when embodiments are found to be without any unexpected characteristics, those embodiments are within the meaning of the term about as used herein. It is not difficult for the artisan or others to determine whether such an embodiment is either as expected or, because of either a break in the continuity of results or one or more features that are significantly better than reported by the inventor, is surprising and thus an unobvious teaching leading to a further advance in the art.

### DETAILED DESCRIPTION OF THE INVENTION

Any process for making textile or reinforcing glass fibers can be used to make glass fibers, mats and performs according to the invention including to the processes disclosed in US Pat. Nos. 3,744,361,4,036,622, 4,083,279, 4,309,202, 4,551,160, 4,576,621, 4,840,755, 6,076,442, 6,202,525, and 6,322,888, the disclosures herein incorporated by reference. In at least most of these references the sizings of the invention can be applied by any fiber applicator including those shown in the above patents, or improved applicators of these types, spraying or by running the fibers through a pool of sizing. The wet sized fibers can be chopped directly as shown in at least most of the above patents or improvements thereon, or wound into roving packages or cakes and chopped wet at a different location using any kind of fiber chopper made for chopping wet glass fiber, sized or unsized.

Mats, laminates and preform of the invention contain mats that typically contain at least about 90 wt. percent fiber less the sizing chemicals, on a dry basis, more typically at least about 93 to about 95 wt. percent and most typically from about 94 to about 99 wt. percent, including about 95-98 wt. percent, fibers, on a dry basis, excluding the sizing. The mats and performs made from these fibers also typically contain up to about 10 weight percent cured binder, more typically about 3-10 wt. percent and most typically about 3-7 wt. percent binder holding the fibers together, exclusive of any additives like pigments, etc. that may be added as the mat is made, or that may be present in the sizing in addition to the sizing chemicals. The majority of the fibers are preferably glass fibers, but other fibers can be present as mentioned above. The wet, sized glass fibers used to make mats can have various fiber diameters and lengths dependent on the strength and other properties desired in the mat as is well known. Typically the majority of the glass fibers have diameters in the range of about 8 up to about 25 microns, with the major portion of the fiber being more typically in the range of about 10 to 19 microns diameter and most typically in the range of about 12 to 17 microns diameter.

The glass fibers can be E glass, C glass, T glass, S glass or any known glass fiber of good strength and durability in the presence of moisture. Normally the glass fibers used all have about the same target length, but fibers of different lengths and different average diameters can also be used to achieve different characteristics in the mat, perform, laminate or composite products in a known manner. Fibers up to about 5 inches or longer in length can be used in a making fiber glass mats and preforms.

While the majority of the fibers used in the mats and preforms of the invention are glass fibers, a minor portion of non-glass fibers can also be used, such as cellulosic fibers including wood pulp of all kinds, cotton linters, cellulose derivatives such as cellulose triacetate, rayon, etc. Man made organic fibers such as Nylon^{™}, polyester, polyethylene, polypropylene, etc. can also be used instead of cellulose fibers in any various blends with one or more cellulosic fibers. The fibers in the mats are bonded together as described earlier.

Processes for making nonwoven fiber glass mats and preforms from wet, sized fibers are known including those disclosed in US Pat. Nos. 3,595,485, 3,771,981, 4,952,366, 4,961,700, 5,819,614, 6,029,897, 6,713,012 and Pub. Pat. App. 2005/0082271 A1, and these processes and other similar or improved processes can be used to lay down mats or preforms in the according to the invention. Some other processes for forming the mats and preforms are disclosed in the examples provided below. The mat or preform of wet, sized fibers can then be transferred to a moving permeable belt, drum, etc., or left on the forming belt, and runs through an oven where the unbonded, wet mat is dried and cured, bonding the fibers together in the mat with the binder in the sizing on the fibers. In production, the dry, cured mat is then usually wound into rolls, or cut into sections, stacked and packaged such as by stretch or shrink wrapping or by putting into a plastic bag to keep out moisture and dirt, etc. Dry preforms are stacked and packaged in a similar manner.

In addition to the types of resin binders disclosed previously for the sizing, nonreactive resins can also be used, particularly for use with polyester matrices. Some examples of this type of resin are disclosed in U.S. Pat. No. 4,981,754, the disclosure herein incorporated by reference. This type of size does not include any substantial amount of free, reactable epoxy, or oxirane groups. One useful resin is a fully reacted, pre-formed reaction product of a diglycidyl ether of a bisphenol, or a halogenated bisphenol, with one or more monocarboxylic acids, or with one or more monohydric alcohols, or mixtures of these. The monocarboxylic acid can also be an acid ester, e.g. the reaction of an alcohol with an anhydride. A particularly useful resin is diglycidyl ether of bisphenol A, or the diglycidyl ether of a halogenated, preferably brominated bisphenol A, preferably a bisphenol A which is fully substituted with bromine atoms. The reaction with the monocarboxylic acid and monhydric alcohol can be done in the presence of isophthalic acid or adipic acid. Thus, when reference is made in the present specification, and claims, to reacting with a monocarboxylic acid or monohydric alcohol providing that the monocarboxylic acids and/or monohydric alcohols are present in amounts that dominate the properties of the reaction product. The reaction product is formed from a mixture consisting essentially of the diglycidyl ether and the acid/alcohol reactants. Typically the total amount of monocarboxylic acid employed (and/or the amount of the monohydric alcohol) will be in a molar ratio to isophthalic acid or adipic acid in excess of about 23:1. The terminal epoxy rings of the reaction product of the diglycidyl ether of a bisphenol or a halogenated bisphenol, preferably bisphenol A is fully reacted so that the resulting reaction product is substantially free of unreacted epoxy rings. These resins can also contain hardening amounts of other, non-epoxy, film forming polymers such as, for example, polyvinyl acetate or polyvinyl pyrrolidone.

Typically, when an aqueous binder sizing solution, emulsion is applied to fibers in a conventional manner using an applicator, or spraying, the viscosity of the sizing is less than about 300 centipoise, usually much less. In this invention, the sizing solution, latex, emulsion or slurry has a viscosity significantly above 300 centipoise such as above 350, even above 400 or 425, and this causes more sizing chemicals, particularly the binder resin(s), to adhere and stay on the surface of the fiber. The higher viscosity is typically achieved by greatly increasing the concentration of binder resin(s) in the sizing. In the invention, the concentration of binder or binder and film forming resin(s) in the sizing is typically at least about 90 wt. percent, more typically at least about 94 wt. percent, and most typically at least about 97 wt. percent, based on the dry weight of sizing chemicals in the sizing, and at least about 4.5 wt. percent and up to 30 wt. percent or more of the liquid in the sizing, typically water, but hydrocarbon solvents can also be used.

### Example 1

Bundles of M diameter E glass fibers having a length of about 3 inches were produced in a known manner and a sizing was applied to the surface of the fibers in a known manner to achieve a loss on ignition, LOI, on the fibers of about 2 wt. percent, based on the dry weight of the glass fibers, the bundles, produced from a fiber chopper in a known manner, contained up to several thousand of the sized fibers and had a moisture content of about 12 wt. percent. The sizing contained about 90 wt. percent PPRL 3974, a polypropylene emulsion having a molecular wt. of less than 10,000, available from the Proctor Chemical Company, and about 10 wt. percent of A-1100 organomethoxysilane available from Union Carbide, based on the dry wt. of the solids in the sizing. The sizing had a solids content of 15 wt. percent. The same sizing, but containing a solids content of about 25 wt. percent was sprayed onto the array of chopped bundles of fibers between the chopper and the collection conveyor. The LOI of the finished wet bundles of fibers was about 4 wt. percent, and the moisture content of the wet, sized fiber bundles was about 16-18 wt. percent.

These bundles of wet fibers were fed with a Brabender gravimetric fiber feeder having a set of rapidly rotating rollers having pins extending from the surface of one roller surface and a second roller set of different geometry to clean retain fibers from the first set of rollers. The rotating rollers reduced the size of the fiber bundles to that conventionally used in fiber reinforced products, and directed the smaller bundles in a uniform array towards a moving, permeable collection belt. The feeding and opening device was mounted above the moving, permeable collection belt where, with the aid of a suction fan pulling air through the collection belt, a uniform web of randomly oriented fibers and fiber bundles was formed. This web was then carried through a convection oven where hot air was drawn through the web to remove the water on the fiber and to cause the film former or binder to lock the fiber bundles together at their cross over points of contact. A mat of fiber bundles having adequate strength for handling, packaging and shipping and rehandling into a forming mold was produced that was particularly useful in molding polypropylene matrix composites.

### Example 2

Fiber bundles similar those produced in Example 1 were produced in the same manner, but the sizing consisted of about 8 wt. percent Epirez 5520 W60, an epoxy resin available from Shell Chemical, 0.9 wt. percent of A-1100 and 2.4 wt. percent of Heloxy 48, a trimethylol propane trigycidyl ether, available from Shell Chemical. The solids content of the sizing was 20 wt. percent. The moisture content of the wet, sized fibers was 22 wt. percent and the LOI was 5.5 wt. percent. The wet, sized bundles was metered with a volumetric feeder with sets of rollers like the feeder used in Example 1, but also having a rapidly moving picker belt having needles or pins extending from the surface that drags fiber bundles from the set of rollers and further opened the bundles into bundles having on average less than 100 fibers per bundle. The pulling of the wet, sized fiber and fiber bundles by the pins on the belt tends to orient many of the fibers and bundles in a direction parallel with the melt movement and can produce a web in which the majority of the fibers and fiber bundles are oriented in either the machine direction or the cross-machine direction, depending on how the picker belt is oriented with respect to the collection belt. A mat made in this example was especially useful in making composites having a polypropylene matrix.

### Example 3

Fiber bundles made as in the prior examples, except with a different sizing were made. The sizing on the fibers consisted of 0.4 wt. percent A 1100, 0.5 wt. percent ethoxylated nonyl phenol having 30 moles of ethylene oxide, and 4.6 wt. percent Nezolyl 962, an epoxy emulsion available from DSM. The solids content of the sizing was 30 wt. percent for spraying and 20 wt. percent for direct application with an applicator located under the bushing. The moisture content of the wet, sized fibers was about 16-18 wt. percent and the LOI was about 6 wt. percent.

The wet, sized fibers and fiber bundles were opened using rapidly moving air from jets in a known manner and carried in the resultant air stream onto the collection belt. After drying and curing in the oven, the resultant mat was particularly useful in making composites having a polyester matrix in processes including RIM and SRIM.

### Example 4

The process of Example 3 was modified by blending 5-10 wt. percent of polymer binder fibers, like polyethylene fibers, into the wet, sized fibers and fiber bundles as they were fed into the volumetric feeder and by using heated air to open and transport the opened wet, sized fibers and fiber bundles and the binder fibers to the collection belt. This hot air, 300-450 degree F., softened and melted the binder fibers and reduced the moisture content of the fibers and fiber bundles somewhat making the collected web easier to dry and bond.

### Example 5

To make a mat laminate that produces a composite having a very smooth surface, the wet, sized fibers and fiber bundles can be collected on a fibrous veil mat laying on the collection belt and/or a veil can also be applied on top of the just collected web of wet, sized fibers and fiber bundles. The wet, sizing on the surface of the fibers and fiber bundles will cause the veil mat to adhere to the fiber bundle web when the web is dried and the binder in the sizing is cured. To achieve an even better bond, where desired, with the web of bundles to the veil mat, the contacting surface of the veil can be sprayed with the sizing used on the fiber prior to bringing it into contact with the fiber bundles. The veil mats can be conventional veil mats of spunbond material or wet formed fibrous veil mats including mats of microfibers.

### Example 6

The invention wet, sized fiber bundles of Example 3 is used to make a preform by using a robot or other mechanical X-Y movable device to move a permeable perform mold around to intersect the moving array of opened, wet, sized fibers and fiber bundles while also pulling an airstream through the mold, and web, to produce a uniform or non-uniform, if desired, perform. If the air is heated, especially in the later stages of formation or after the preform is formed, the perform is quickly dried, or dried sufficiently to separate it from the mold and to place it onto a dryer belt for finishing the drying and curing of the resin binder. A veil mat can be placed on the mold surface before laying down the web of wet, sized fibers and fiber bundles when desired, to produce a veiled surface. Also, a film layer or a decorative layer can be added to the surface of the preform before drying and will bond to the preform during drying.

### Example 7

When the above processes are used to produce a preform instead of a fibrous mat, the wet sized and chopped fiber of the invention is propelled onto a permeable form of the desired shape in a conventional manner without having to add any further binder to the fiber or the wet preform. When the finished wet preform is dried, the sizing on the fiber is sufficient to bond the fibers and fiber strands together sufficiently to handle the preform into a RIM press, or other composite molding operation, or to package and ship the preforms to a customer.

A modification can be made to produce a preform having a hollow core for a one-shot RTM process. Normally an inflatable silicon bag is used to create a void in the center of the preform, i.e. e. after about one-half of the perform is built up, the silicon bag is placed on the layer of collected, wet, sized fiber bundles and then surrounded or mostly surrounded by forming another layer of a web of wet, sized fiber bundles over the silicon bag. The silicon was later removed, a time consuming process. In the present invention, two pieces, or a single piece, of polymer film, such as a polyester film or Mylar^{™} or other similar films are formed into a flat bag having any desired shape with the edges bonded together tightly or loosely, such as fused together or merely stuck together by a fold or any kind of adhesive bond, and having a tube extending into the interior and placed on a wet layer of fibrous preform . The film bag is smaller in X-Y dimensions than the partial preform such that wet preform extends beyond the bag on at least three sides any desired distance. The preform is then completed, and while still wet, the bag is inflated with air, etc. to the desired shape and the preform is dried to form a preform having a hollow core. The inflated film bag is left in the preform in an inflated form such that it prevents the resin matrix added later in the RIM or other process from entering the hollow space occupied by the film bag. It is not necessary to remove the film bag from the preform or finished part, thus saving labor and time.

The mats, preforms and laminates made according to the invention can be used for liquid resin injection molding processes including RTM, VARTM, RIM, SRIM and spray-on systems, and also SMC and GMT processes for making fiber reinforced composites from thermoplastic, thermoset and reactive thermoplastics such as cast nylons, cyclic PBT and others.

Several of the most typical embodiments of the invention have been set forth above, but having the benefit of this disclosure; many other modifications will be obvious to the ordinary artisan. All such embodiments not showing unexpected results naturally are enabled by, and are a result of, the invention and are intended to be included in the scope of the following claims.

## Claims

1. A sizing composition for coating glass fibers comprising a liquid and solids comprising one or more binder resins, one or more silanes and one or more lubricants, the viscosity of the sizing being greater than about 300 centipoise and the concentration of the binder resin being at least about 90 weight percent, based on the dry weight of chemicals in the sizing, the solids concentration of the sizing being at least about 5 weight percent.

2. The sizing composition of claim 1 wherein the concentration of binder resin is at least about 95 wt. percent.

3. The sizing composition of claim 1 wherein the concentration of binder resin is at least about 97 wt. percent.

4. The sizing composition of claim 1 wherein the concentration of binder resin is at least about 98 wt. percent.

5. The sizing composition of claim 1 wherein the concentration of binder resin is at least about 99 wt. percent.

6. The sizing of claim 1 wherein the solids concentration in the sizing is at least about 10 wt. percent.

7. The sizing of claim 2 wherein the solids concentration in the sizing is at least about 10 wt. percent.

8. The sizing of claim 3 wherein the solids concentration in the sizing is at least about 10 wt. percent.

9. The sizing of claim 3 wherein the solids concentration in the sizing is at least about 10 wt. percent.

10. The sizing of claim 4 wherein the solids concentration in the sizing is at least about 10 wt. percent.

11. The sizing of claim 5 wherein the solids concentration in the sizing is at least about 10 wt. percent.

12. The sizing of claim 1 wherein the solids concentration in the sizing is at least about 15 wt. percent.

13. The sizing of claim 2 wherein the solids concentration in the sizing is at least about 15 wt. percent.

14. The sizing of claim 3 wherein the solids concentration in the sizing is at least about 15 wt. percent.

15. The sizing of claim 3 wherein the solids concentration in the sizing is at least about 15 wt. percent.

16. The sizing of claim 4 wherein the solids concentration in the sizing is at least about 15 wt. percent.

17. The sizing of claim 5 wherein the solids concentration in the sizing is at least about 15 wt. percent.

18. The sizing of claim 3 wherein the solids concentration in the sizing is at least about 20 wt. percent.

19. The sizing of claim 4 wherein the solids concentration in the sizing is at least about 20 wt. percent.

20. The sizing of claim 5 wherein the solids concentration in the sizing is at least about 20 wt. percent.

21. Wet, sized glass fibers having on their surface a sizing comprising a liquid and solids comprising one or more binder resins, one or more silanes and one or more lubricants, the viscosity of the sizing being greater than about 300 centipoise and the concentration of the binder resin being at least about 90 weight percent, based on the dry weight of chemicals in the sizing, the solids concentration of the sizing being at least about 5 weight percent and an LOI of the sized fiber after drying being at least about 1 wt. percent.

22. Wet, sized glass fibers of claim 21 and wherein the LOI is at least about 3 wt. percent.

23. Wet, sized glass fibers having of claim 21 wherein the resin content is at least about 98 wt. percent and the LOI is at least about 3 wt. percent.

24. Wet, sized glass fibers of claim 21 wherein the resin content is at least about 98 wt. percent and the LOI is at least about 4 wt. percent.

25. Wet, sized glass fibers of claim 21 wherein the length of the fibers is at least about 0.5 inch and the LOI is at least about 1.5 wt. percent.

26. Wet, sized glass fibers of claim 21 having a length of at least about 1 inch, a resin concentration of at least about 98 wt. percent and the LOI of is least about 1 wt. percent.

27. A method of making fibrous nonwoven mats comprising randomly placing wet sized glass fibers having on their surface a sizing comprising a liquid and solids comprising one or more binder resins, one or more silanes and one or more lubricants, the concentration of the binder resin being at least about 90 weight percent, based on the dry weight of chemicals in the sizing, the solids concentration of the sizing being at least about 5 weight percent and an LOI of the fibers being at least about 1 wt. percent, onto a moving collection belt or a permeable form to form a wet, nonwoven mat and then heating the wet nonwoven mat to dry the mat and to cure the binder from the sizing on the fibers to an extent to bind the fibers in the mat together where the fibers contact one another.

28. The method of claim 27 wherein the resin content of the sizing is at least about 97 wt. percent of the dry solids.

29. The method of claim 27 wherein the resin content of the sizing is at least about 99 wt. percent of the dry solids.

30. The method of claim 28 wherein the LOI on the fiber is at least about 2 wt. percent.

31. The method of claim 29 wherein the LOI on the fiber is at least about 3 wt. percent.

32. The method of claim 28 wherein the LOI on the fiber is at least about 4 wt. percent.

33. The method of claim 29 wherein the LOI on the fiber is at least about 5 wt. percent.

34. A method of making a fibrous preform comprising randomly placing wet sized glass fibers having on their surface a sizing comprising a liquid and solids comprising one or more binder resins, one or more silanes and one or more lubricants, the concentration of the binder resin being at least about 90 weight percent, based on the dry weight of chemicals in the sizing, the solids concentration of the sizing being at least about 5 weight percent and an LOI of the fibers being at least about 1 wt. percent, onto a form to produce a wet, nonwoven preform and then heating the wet preform to dry the preform and to cure the binder from the sizing on the fibers to an extent to bind the fibers in the preform together where the fibers contact one another.

35. The method of claim 34 wherein the resin content of the sizing is at least about 97 wt. percent.

36. The method of claim 34 wherein the resin content of the sizing is at least about 99 wt. percent.

37. The method of claim 35 wherein the LOI on the fiber is at least about 3 wt. percent.

38. The method of claim 36 wherein the LOI on the fiber is at least about 3 wt. percent.

39. The method of claim 35 wherein the LOI on the fiber is at least about 4 wt. percent.

40. The method of claim 36 wherein the LOI on the fiber is at least about 4 wt. percent

41. A method of making wet, sized glass fibers comprising forming glass fibers from a molten glass and applying to the glass fibers a latex sizing, the improvement comprising that the sizing comprises a liquid and solids comprising one or more binder resins, one or more silanes and one or more lubricants, the viscosity of the sizing being greater than about 300 centipoise and the concentration of the binder resin being at least about 90 weight percent, based on the dry weight of chemicals in the sizing, the solids concentration of the sizing being at least about 5 weight percent, the LOI of the sized fibers being at least about 1 wt. percent.

42. The method of claim 41 wherein the concentration of binder resin is at least about 95 wt. percent.

43. The method of claim 41 wherein the concentration of binder resin is at least about 97 wt. percent.

44. The method of claim 41 wherein the concentration of binder resin is at least about 98 wt. percent.

45. The method of claim 41 wherein the concentration of binder resin is at least about 99 wt. percent.

46. The method of claim 44 wherein the solids concentration in the sizing is at least about 10 wt. percent.

47. The method of claim 45 wherein the solids concentration in the sizing is at least about 10 wt. percent.

48. The wet sized fiber of claim 21 wherein the wet sized fibers are in the form of a wound roving package.

49. The wet sized fiber of claim 21 wherein the wet sized fibers are in the form of chopped fiber strands having a length in the range of about 0.5 to about 5 inches.

50. The wet sized fiber of claim 49 wherein the moisture content of the wet sized fiber is in a range of about 0.5 to about 20 wt. percent or higher.

51. The wet sized fiber of claim 48 wherein the moisture content of the wet sized fiber is in a range of about 0.5 to about 20 wt. percent or higher.

52. The wet sized fiber of claim 49 wherein the moisture content of the wet sized fiber is in a range of about 0.5 to about 8 wt. percent.

53. The method of claim 27 wherein a veil mat is applied to a surface of the wet, nonwoven mat by either collecting laying the veil mat onto the collection belt prior to forming the wet, nonwoven mat, or by applying the veil onto the surface of the wet, nonwoven mat before heating.

54. The method of claim 27 wherein a layer of nonwoven dry non-glass in a random pattern is formed on the collection belt to form a veil mat prior to forming the wet, nonwoven mat.

55. The method of claim 53 wherein the veil mat is a spunbond fiber mat.

56. The method of claim 27 wherein chopped non-g lass fiber is dispersed into the wet sized glass fiber prior to forming the wet nonwoven mat.

57. The method of claim 34 wherein a veil mat is applied to a surface of the preform before heating by either placing it on the mold before laying down the wet, sized fiber or by placing the veil mat onto the top surface of the wet preform prior to heating.

58. The method of claim 34 wherein a layer of nonwoven dry non-glass in a random pattern is formed on the permeable form prior to forming the wet, nonwoven preform.

59. The method of claim 57 wherein the veil mat is a spunbond fiber mat.

60. The method of claim 34 wherein during the process of building up the wet, nonwoven preform, the process is interrupted to place a film bag onto the wet surface of the incomplete preform and then the process of placing wet, sized glass fiber is resumed, directing the wet, sized fibers onto the film bag and later onto a partial preform until the desired thickness is achieved, blowing a gas into the bag to form a hollow core in the preform and then drying the preform while maintaining a hollow core in the preform.

61. The method of claim 34 wherein chopped non-g lass fiber is dispersed into the wet sized glass fiber prior to forming the preform.

62. The wet sized fiber of claim 26 wherein the wet sized fibers are in the form of a wound roving package.

63. The wet sized fiber of claim 26 wherein the wet sized fibers are in the form of chopped fiber strands having a length in the range of about 0.5 to about 5 inches.

64. The wet sized fiber of claim 48 wherein the moisture content of the wet sized fiber is in a range of about 0.5 to about 8 wt. percent.

65. The wet sized fiber of claim 48 wherein the moisture content of the wet sized fiber is in a range of about 0.5 to about 6 wt. percent.

66. The wet sized fiber of claim 49 wherein the moisture content of the wet sized fiber is in a range of about 0.5 to about 6 wt. percent.
